Europäisches Patentamt

European Patent Office

Office européen des brevets

(11) Numéro de publication : **0 501 896 A2**

## (12) DEMANDE DE BREVET EUROPEEN

(21) Numéro de dépôt : **92420047.0**

(22) Date de dépôt : **12.02.92**

(51) Int. Cl.⁵ : **H01L 29/08,** H01L 29/73, **H01L 27/06**

(30) Priorité : **13.02.91 FR 9101984**

(43) Date de publication de la demande :
**02.09.92 Bulletin 92/36**

(84) Etats contractants désignés :
**AT CH DE ES FR GB IT LI NL**

(71) Demandeur : **FRANCE TELECOM**
**Etablissement autonome de droit public, 6,**
**Place d'Alleray**
**F-75015 Paris (FR)**

(72) Inventeur : **Nouailhat, Alain**
**26 Rue du Pré d'Elle**
**F-38240 Meylan (FR)**
Inventeur : **Bois, Daniel**
**140 Allée Chantoiseau**
**F-38330 Saint-Ismier (FR)**

(74) Mandataire : **Thibault, Jean-Marc**
**Cabinet Beau de Loménie 51, Avenue Jean**
**Jaurès B.P. 7073**
**F-69341 Lyon Cédex 07 (FR)**

(54) **Perfectionnement au collecteur d'un transistor bipolaire compatible avec la technologie MOS.**

(57) — Le transistor bipolaire comprend un substrat (**1**) semi-conducteur, d'un premier type de conductivité (**P**), un caisson rétrograde (**3**) servant de collecteur et présentant un second type de conductivité (**N**) opposée du premier, une région active de base (**4, 5**) présentant une conductivité du premier type, une région (**6**) servant d'émetteur de conductivité de second type, les régions (**4, 5, 6**) étant bordées de part et d'autre par une région isolante. Selon l'invention, le transistor comporte une zone (**11**) du second type de conductivité servant de contact de collecteur, localisée dans une région du caisson rétrograde (**3**), à distance de la zone de base (**4, 5**) et s'étendant, au plus, à partir de la zone de base, au droit de la zone isolante (**2**).

— Application à la réalisation de circuits du type BI MOS ou BI - CMOS.

Fig_2A

EP 0 501 896 A2

La présente invention concerne le domaine technique général de la réalisation d'un transistor bipolaire compatible avec la technologie MOS et mettant en oeuvre avantageusement un caisson rétrograde.

L'invention vise, plus particulièrement, un perfectionnement du collecteur d'un tel transistor bipolaire.

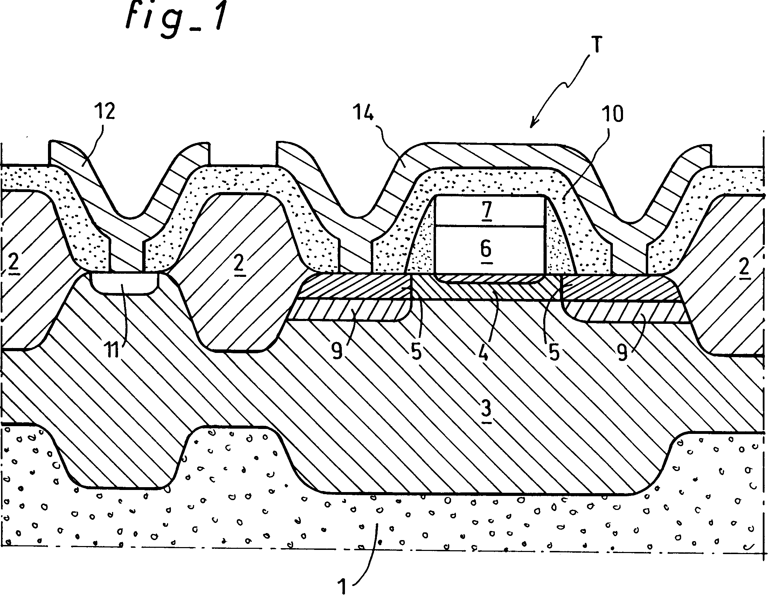

L'art antérieur a proposé, par la demande de brevet en France n° **2 626 406**, un transistor bipolaire compatible avec la technologie MOS. Tel que cela apparaît plus précisément à la **fig. 1,** le transistor bipolaire **T** est réalisé à partir d'un substrat semi-conducteur **1** présentant un premier type de conductivité, par exemple du type **P**. A partir d'une face principale du substrat **1,** il est prévu de réaliser, d'une part, des zones isolantes latérales, cloisons épaisses ou zones d'oxyde épais **2** par la technique classique appelée LOCOS ("local oxidation of silicon") et, d'autre part, une région active **3** de la jonction du transistor constituée par un caisson rétrograde permettant classiquement d'obtenir, par implantation profonde, des concentrations élevées en profondeur. Le caisson rétrograde **3,** qui sert de collecteur, possède un second type de conductivité opposée au premier, à savoir du type **N** dans l'exemple préféré choisi.

Entre deux zones isolantes **2,** il est prévu d'implanter, dans un plan superficiel de la région de collecteur **3,** une région active **4** de base présentant une conductivité de type **P,** bordée de part et d'autre par des régions de contact **5** de la base. Les régions **5** sont dopées fortement et superficiellement après la formation de l'émetteur et des espaceurs décrite ci-après, afin de former des régions de contact de base de très faible résistivité appelées régions de base extrinsèques **9.**

Une région active d'émetteur **6,** de type $N^+$, est formée pour couvrir sensiblement la face principale du substrat au niveau de la région de base **4.** La région d'émetteur **6** est surmontée par une région **7** de contact d'émetteur réalisée en silicide de tungstène $WSi_2$. Une couche isolante **10** d'oxyde de silicium est ensuite déposée sur la face principale du substrat dans laquelle les fenêtres sont ménagées par photogravure localisée, afin d'accéder aux régions de contact de base **5** et d'implanter une région de contact de collecteur **11,** du type $N^+$, ménagée entre deux zones isolantes **2.** Il est ensuite procédé à une métallisation pour réaliser, au niveau des fenêtres, des contacts métalliques de collecteur **12** et de base **14.**

Un tel transistor, qui présente une structure autoalignée au niveau de l'émetteur-base, permet d'améliorer le système émetteur-base aux fortes densités de courant. Si une telle structure apporte des avantages indéniables par rapport à l'état de la technique, il convient, toutefois, de considérer que ce transistor présente une résistance de collecteur importante. De plus, la réalisation d'un contact collecteur superficiel introduit une résistance supplémentaire parasite.

La présente invention vise donc à proposer un transistor bipolaire compatible avec la technologie MOS et dont la résistance du collecteur est considérablement améliorée par rapport aux solutions connues de l'état de la technique.

Pour atteindre cet objectif, le transistor bipolaire comprend un substrat semi-conducteur, d'un premier type de conductivité, un caisson rétrograde servant de collecteur et présentant un second type de conductivité opposée du premier, une région active de base présentant une conductivité du premier type, une région servant d'émetteur de conductivité de second type, les régions de base et d'émetteur étant bordées de part et d'autre par une région isolante.

Selon l'invention, le transistor bipolaire comporte au moins une zone du second type de conductivité servant de contact de collecteur, localisée dans une région du caisson rétrograde, à distance de la zone de base et s'étendant, au plus, à partir de la zone de base, au droit de la zone isolante.

Selon une première forme de réalisation, chaque zone servant de contact collecteur est réalisée au bord d'une zone isolante du côté de la région de base.

Pour améliorer encore le contact collecteur, il peut être prévu que chaque zone servant de contact collecteur est réalisée sensiblement au droit d'une zone isolante et se trouve en relation d'une tranchée traversant la zone isolante de part en part.

Diverses autres caractéristiques ressortent de la description faite ci-dessous en référence aux dessins annexés qui montrent, à titre d'exemples non limitatifs, des formes de réalisation de l'objet de l'invention.

La **fig. 1** est une vue en coupe schématique d'un transistor bipolaire NPN de l'état de la technique du type polycide $WSi_2$.

La **fig. 2A** est une vue en coupe schématique d'une première variante de réalisation, selon l'invention, d'un collecteur d'un transistor bipolaire faisant appel à la technique polycide.

La **fig. 2B** est une vue de la première variante de réalisation d'un collecteur d'un transistor bipolaire faisant appel à la technique salicide.

La **fig. 3A** est une vue en coupe schématique d'une seconde variante de réalisation conforme à l'invention d'un collecteur d'un transistor bipolaire faisant appel à la technique polycide.

La **fig. 3B** est une vue de la seconde variante de réalisation d'un collecteur d'un transistor bipolaire faisant appel à la technique salicide.

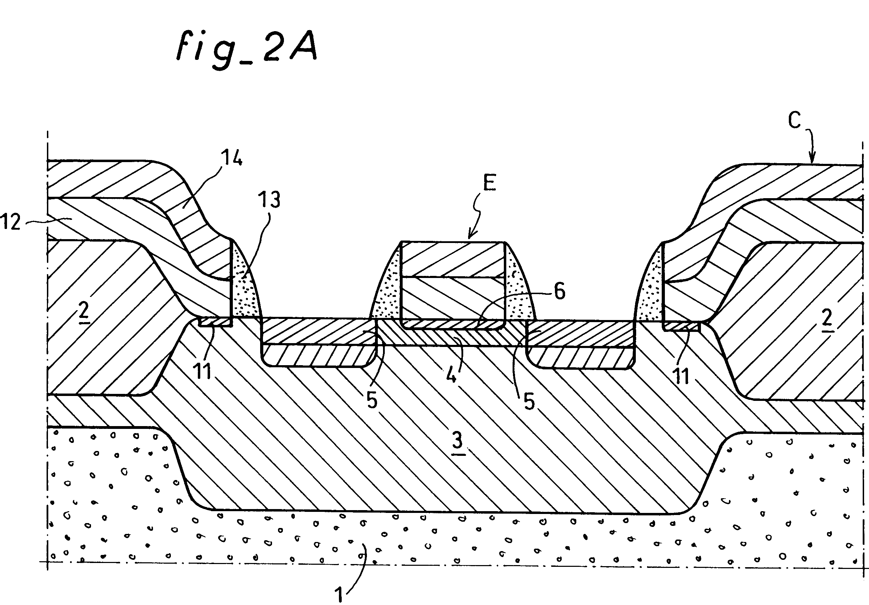

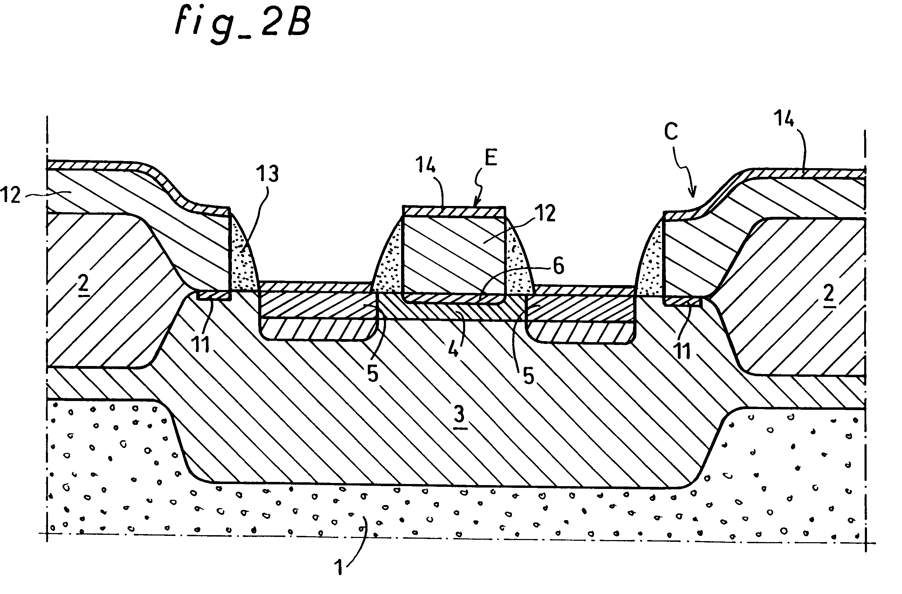

La **fig. 2A** illustre un exemple de réalisation d'un transistor bipolaire compatible avec la technologie MOS et dont les caractéristiques principales ont été réalisées selon la technique décrite dans la demande de brevet française n° **2 626 406.** Le transistor bipolaire est réalisé à partir d'un substrat semi-conducteur **1** présentant un premier type de conductivité, par exemple du type **P.** A partir d'une face principale du substrat **1,** des zones isolantes **2** sont implantées par la technique classique LOCOS ("local oxidation of silicon"). Le substrat présente également une région 3 constituée par un caisson rétrograde destiné à renfermer la zone active de la jonction **NPN** du transistor. Le caisson rétrograde **3**, qui sert de collecteur, possède un second type de conductivité opposée au premier, à savoir du type **N** dans l'exemple préféré choisi. Dans le caisson **3** est implantée une région active de base **4**, de type **P**, prolongée latéralement de part et d'autre par des régions extrinsèques de contact de base **5** qui sont auto-alignées par rapport à l'émétteur.

Conformément à l'invention, il est prévu de réaliser au moins une, et dans l'exemple illustré, deux zones **11** du type $N^+$ servant de contact collecteur et localisées entre deux zones isolantes **2**, du côté des régions de base en étant espacées de ces dernières.

La **fig. 2A** décrit une première forme de réalisation des zones de contact collecteur **11** par la technique connue du type polycide. Selon cette technique, il est prévu de réaliser, sur la face du substrat, un revêtement complexe siliciuré, obtenu par le dépôt d'une couche de polysilicium **12** recouvert par une couche de siliciure ou de métal **14**, soumis ensuite à un recuit. Un tel revêtement **12, 14** de polysilicium et siliciure est ensuite éliminé, par masquage et photogravure, à l'exception, d'une part, d'une région de contact d'émetteur $\underline{E}$ formant une région active d'émetteur **6** réalisée au niveau de la région active de base **4** et obtenue par diffusion et, d'autre part, des régions s'étendant au-dessus des zones isolantes **2** et de zones **11** bordant ces zones isolantes **2**, du côté des régions de base. Ces régions **11** qui sont obtenues par diffusion dans le caisson **3**, à partir de la couche **12**, constituent les zones de contact collecteur.

Les parties restantes du revêtement **12, 14** constituent donc les contacts collecteurs $\underline{C}$ et émetteurs $\underline{E}$. De manière classique, il est prévu de réaliser des espaceurs isolants **13** sur les bords latéraux des contacts collecteurs $\underline{C}$ et d'émetteurs $\underline{E}$, en s'étendant entre les zones de contact collecteur **11** et les zones de base extrinsèques **5**.

La réalisation des zones de contact de collecteur **11**, au niveau des zones isolantes **2**, permet de réduire la résistance du collecteur, dans la mesure où la zone de contact **11** se trouve, au plus prés de la région de base extrinsèque **5**. Avantageusement, les zones de contact de collecteur **11** sont obtenues par diffusion, simultanément à la réalisation de la région active d'émetteur **6** qui est également obtenue par diffusion de dopants à partir de la couche **12**.

La **fig. 2B** illustre la réalisation des zones de contact collecteur **11** à l'aide de la technique connue du type salicide ("Self Aligned Silicide"). Selon cette technique, il est prévu de déposer sur la face du substrat, après la réalisation des zones **2, 3, 4, 5,** une couche **12** de polysilicium qui est ensuite éliminé par masquage et photogravure à l'exception de la région active d'émetteur **6** et des zones de contact collecteur **11**, comme décrit dans la technique ci-dessus. Après la formation des espaceurs isolants **13** et de la base extrinsèque **5**, la surface est recouverte d'une couche de métal **14** (par exemple du Titane) pour former un siliciure sélectif sur les zones de silicium **12** et de polysilicium de base **5**.

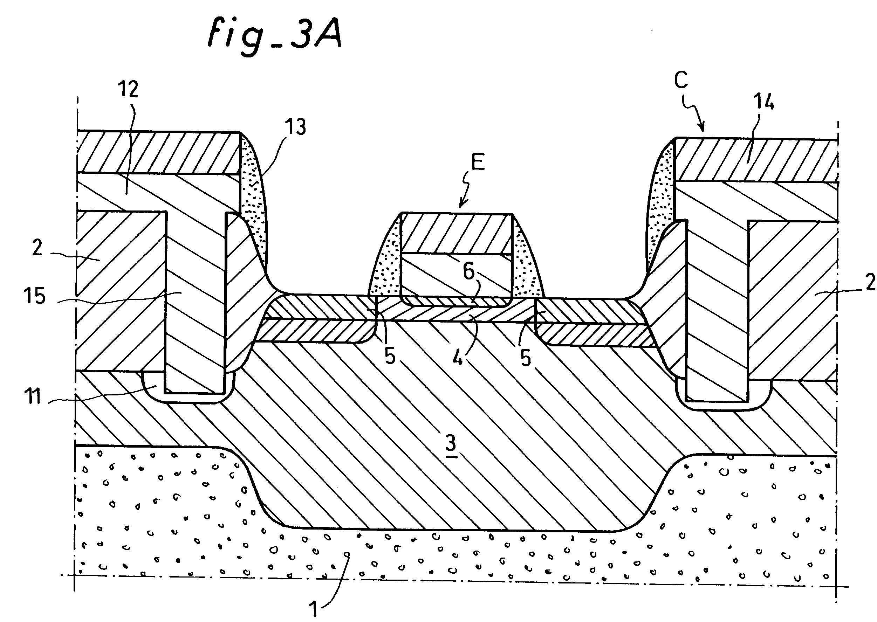

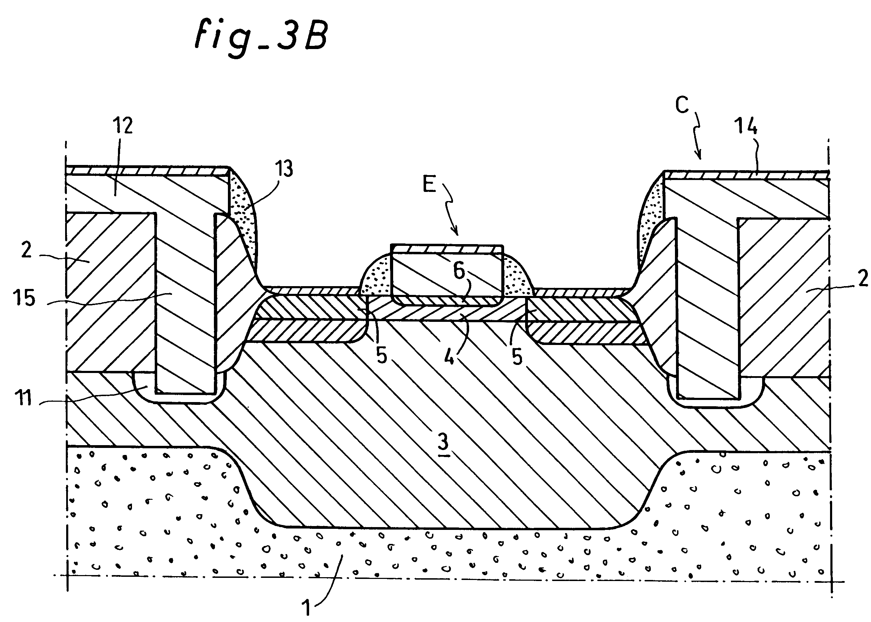

Les **fig. 3A** et **3B** illustrent une seconde variante de réalisation d'un nouveau collecteur conforme à l'invention. Les différentes zones caractéristiques identiques à celles illustrées aux **fig. 2A, 2B** comportent des références identiques. Selon cette variante de réalisation, il est prévu de ménager, après la réalisation des zones **2** et **3**, par les techniques classiques de gravure et de masquage, des tranchées **15** traversant de part en part les zones isolantes **2** pour déboucher au niveau du caisson rétrograde **3**. Les tranchées **15** débouchent ainsi, avantageusement, au niveau du caisson dans la zone la plus fortement dopée du caisson. Ensuite, il est procédé à une implantation d'un dopant du type $N^+$, au droit de ces tranchées et dans le caisson **3**, de manière à former les zones de contact collecteur **11**. Il est ensuite prévu de déposer une couche de polysilicium **12** qui remplit ces tranchées pour assurer un contact avec les zones de contact collecteur **11**. La couche **12** est recouverte d'une couche **14** dont la nature et les conditions de mise en oeuvre dépendent des techniques utilisées, à savoir polycide (**fig. 3A**) ou salicide (**fig. 3B**), décrites respectivement aux **fig. 2A-2B**.

Selon cette seconde variante, le contact collecteur est directement établi au niveau de la zone fortement dopée ou de maximum de dopage du caisson rétrograde, située sensiblement au droit ou à l'aplomb des zones isolantes **2**. Le contact collecteur est ainsi largement amélioré par l'utilisation de telles tranchées. La résistance de collecteur peut être améliorée d'un facteur **10** environ par l'utilisation d'une telle technique.

Il apparaît donc que la mise en oeuvre d'au moins une zone **11** de contact de collecteur s'étendant, au plus à partir de la zone de base **4**, au droit d'une zone isolante **2**, permet d'éliminer la résistance apparaissant sur le transistor bipolaire de l'art antérieur (**fig. 1**) entre la zone **11** et l'aplomb de la zone isolante **2**.

Le transistor bipolaire intégrant le perfectionnement relatif à la réalisation du contact collecteur se trouve particulièrement adapté par la réalisation des circuits du type BI MOS ou BI - CMOS.

Le perfectionnement du collecteur selon l'invention a été décrit en relation d'un transistor bipolaire réalisé selon la technique décrite dans la demande de brevet en référence. Bien entendu, il peut être prévu de mettre en oeuvre un tel perfectionnement pour d'autres types de transistors bipolaires de technologie compatible MOS. A cet égard, il peut être envisagé d'utiliser un tel perfectionnement pour une autre configuration d'émetteur et de base. De plus, il peut être prévu de réaliser uniquement un seul contact collecteur $\underline{C}$.

L'invention n'est pas limitée aux exemples décrits et représentés, car diverses modifications peuvent y être apportées sans sortir de son cadre.

## Revendications

1 - Transistor bipolaire comprenant un substrat (1) semi-conducteur, d'un premier type de conductivité (P), un caisson rétrograde (3) servant de collecteur et présentant un second type de conductivité (N) opposée du premier, une région active de base (4, 5) présentant une conductivité du premier type, une région (6) servant d'émetteur de conductivité de second type, les régions (4, 5, 6) étant bordées de part et d'autre par une région isolante,
caractérisé en ce qu'il comporte au moins une zone (11) du second type de conductivité servant de contact de collecteur, localisée dans une région du caisson rétrograde (3), à distance de la zone de base (4, 5) et s'étendant, au plus, à partir de la zone de base, au droit de la zone isolante (2).

2 - Transistor selon la revendication 1, caractérisé en ce qu'il comporte deux zones (11) de second type de conductivité servant de contact de collecteur, ménagées chacune en relation du caisson rétrograde (3) et s'étendant, au plus, à partir de la zone de base, au droit d'une zone isolante associée (2).

3 - Transistor selon la revendication 1 ou 2, caractérisé en ce que chaque zone (11) servant de contact de collecteur est réalisée sensiblement au droit d'une zone isolante (2) et se trouve en relation d'une tranchée (15) traversant la zone isolante (2) de part en part et remplie d'une couche de polysilicium (12) pour déboucher dans une zone fortement dopée du caisson rétrograde (3).

4 - Transistor selon la revendication 3, caractérisé en ce que chaque zone (11) est réalisée par implantation d'un dopant, au droit des tranchées (15) et dans le caisson (3).

5 - Transistor selon la revendication 1 ou 2, caractérisé en ce que chaque zone (11) servant de contact collecteur est réalisée au bord d'une zone isolante (2) du côté de la région de base (4, 5).

6 - Transistor selon la revendication 5, caractérisé en ce que chaque zone (11) servant de contact collecteur est réalisée par diffusion dans le caisson (3).

7 - Transistor selon la revendication 6, caractérisé en ce que chaque zone (11) servant de contact collecteur est obtenue par diffusion, par le dépôt d'une couche (12) de polysilicium qui assure simultanément, par diffusion, la réalisation de la région active d'émetteur (6).

8 - Transistor selon la revendication 3 ou 7, caractérisé en ce que la couche (12) est recouverte par une couche (14) permettant la formation d'un revêtement complexe de polysilicium et de siliciure, obtenue par la technique polycide.

9 - Transistor selon la revendication 3 ou 7, caractérisé en ce que la couche (12) est recouverte par une couche (14) permettant la formation d'un siliciure sélectif obtenu par la technique salicide.

Fig_1

EP 0 501 896 A2

fig_2A

EP 0 501 896 A2

Fig_2B

fig_3A

EP 0 501 896 A2

Fig_3B